# EUROPÄISCHE PATENTSCHRIFT

(11) **EP 1 260 123 B1**
(45) Veröffentlichungstag und Bekanntmachung des Hinweises auf die Patenterteilung: **06.10.2004**
(21) Anmeldenummer: 01903730.8
(22) Anmeldetag: 09.02.2001
(51) Int. Cl.: H05K 7/20, H02B 1/56

(54) **SCHALTGEHÄUSE MIT EINEM KÜHLGERÄT**
SWITCH HOUSING WITH A COOLING DEVICE
BOITIER D'ARMOIRE DE DISTRIBUTION DOTE D'UN APPAREIL DE REFROIDISSEMENT

(30) Priorität: 18.02.2000 DE 10007467
(43) Veröffentlichungstag der Anmeldung: 27.11.2002
(73) Patentinhaber: Rittal GmbH & Co. KG, 35745 Herborn (DE)
(72) Erfinder: EDELMANN, Achim, 57234 Wilnsdorf (DE)
(74) Vertreter: Fleck, Hermann-Josef, Dr.-Ing.
(86) Internationale Anmeldenummer: PCT/EP2001/001437
(87) Internationale Veröffentlichungsnummer: WO 2001/062058

(56) Entgegenhaltungen:
- EP-A- 0 400 335
- WO-A-91/06995
- US-A- 4 921 039
- US-A- 5 203 399
- US-A- 5 504 924

## Beschreibung

Die Erfindung betrifft ein Schaltgehäuse mit einem Kühlgerät, das einen Kältekreislauf mit einem Verdampfer und einem Verflüssiger aufweist, wobei das Schaltgehäuse eine Außenverkleidung aufweist, die einen Schaltgehäuse-Innenraum zumindest teilweise umgibt, und wobei im Schaltgehäuse-Innenraum eine Montageplatte gehalten ist.

Aus dem Stand der Technik sind derartige Schaltgehäuse bekannt. Auf der Montageplatte können elektrische oder elektronische Einbauten im Schattgehäuse-Innenraum positioniert werden. Diese Komponenten setzen bei ihrem Betrieb eine Verlustleistung in Form von Wärme frei. Um eine unzulässige Überhitzung im Innenraum des Schaltgehäuses zu vermeiden, ist das Kühlgerät verwendet. Es tauscht die entstandene Wärmemenge in die Umgebung ab. Diese Kühlgeräte bedingen regelmäßig einen hohen Wartungsaufwand, da insbesondere die verwendeten Lüfter regelmäßig zu überprüfen und im Schadensfall zu tauschen sind.

Es ist Aufgabe der Erfindung, ein Schaltgehäuse der eingangs erwähnten Art zu schaffen, bei dem das Kühlgerät einen einfachen Aufbau aufweist und gleich-zeitig wartungsfreundlich ausgestaltet ist.

Diese Aufgabe wird dadurch gelöst, dass die Montageplatte als Verdampfer ausgebildet ist, dem ein Rohrleitungssystem zugeordnet ist, in dem das Kältemittel des Kältekreislaufes geführt ist, dass der Verflüssiger zumindest einen Teil der Außenverkleidung bildet, und dem ebenfalls ein Rohrleitungssystem für das Kältemittel zugeordnet ist, und dass das Kühlgerät ventilatoren- bzw. lüfterfrei ausgestaltet ist.

Bei dieser Anordnung können die elektrischen bzw. elektronischen Komponenten auf der Montageplatte befestigt werden. Sie geben die Verlustleistung direkt an die gekühlte, als Verdampfer ausgebildete Montageplatte ab. Die Verlustleistung wird dann letztendlich mit dem im Kältekreislauf geführten Kältemittel abtransportiert und dem Verflüssiger zugeleitet. Der Verflüssiger selbst tauscht die Wärme dann mit der Umgebung aus. Bei diesem Kühlgerät wird auf den Einsatz der wartungsintensiven Lüfter verzichtet.

Gemäß einer bevorzugten Erfindungsausgestaltung ist es vorgesehen, dass der Verflüssiger, die Montageplatte und ein Kompressor zu einer Montageeinheit zusammengefaßt und betriebsbereit miteinander verbunden sind. Die Montageeinheit läßt sich damit auf einfache Weise an ein vorhandenes Schaltgehäuse anbauen.

Um zu verhindern, dass eine Rückübertragung der abgeführten Wärme von dem Verflüssiger in den Schaltgehäuse-Innenraum stattfindet, ist es gemäß einer Erfindungsvariante vorgesehen, dass der Verflüssiger auf seiner, dem Schaltgehäuse-Innenraum zugewandten Seite mittels einer Isolierschicht hinterlegt ist.

Dabei kann es insbesondere auch vorgesehen sein, dass der Verflüssiger plattenförmig ausgebildet ist, und parallel beabstandet zu der Montgeplatte gehalten ist, und dass im Zwischenraum zwischen der Montageplatte und dem Verflüssiger die Isolierschicht eingebracht ist, die den Verflüssiger gegenüber der Montageplatte thermisch entkoppelt.

Ein guter, großflächiger Wärmeabtausch in die Umgebung kann dann stattfinden, wenn der Verflüssiger aus einem wärmeleitfähigen Material besteht, das in das zugeordnete Rohrleitungssystem eingegossen ist. Dabei kann der Verflüssiger auch auf seiner, der Umgebung zugeordneten Außenseite einstückig angeformte Kühlrippen aufweisen.

Denkbar ist es auch, die Montageplatte aus einem wärmeleitfähigen Material besteht, in das das zugeordnete Rohrleitungssystem eingegossen ist. Hierdurch ergibt sich eine kompakte, einheitlich handhabbare Einheit. Die Verwendung dieser Einheit vereinfacht die Montage des Kühlgerätes.

Um eine gute Wärmeabfuhr von den elektrischen bzw. elektronischen Komponenten zu erreichen, ist es vorgesehen, dass die Montageplatte eine, dem Schaltgehäuse-Innenraum zugekehrte ebene Montagefläche aufweist, die mit Befestigungsaufnahmen versehen ist.

Die Erfindung wird im Folgenden anhand eines in der Zeichnung dargestellten Ausführungsbeispieles näher erläutert. Es zeigen:
- Fig. 1: ein Kühlgerät in schematischer Darstellung und in Draufsicht und
- Fig. 2: eine vergrößerte Schnittdarstellung, entlang der in Fig. 1 angegebenen Schnittlinie II-II

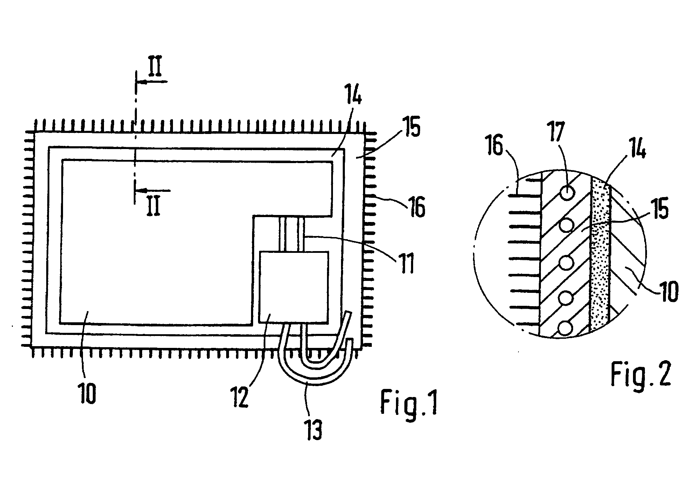

In der Fig. 1 ist ein Kühlgerät dargestellt, das als vormontierte Einheit ausgebildet ist. Es weist einen Kältekreislauf mit einem Verdampfer 10 und einem Verflüssiger 15 auf. Der Verdampfer 10 ist als Montageplatte ausgebildet und mit einem Raster von in gleichmäßiger Teilung zueinander beabstandeten Befestigungsaufnahmen versehen. Die Befestigungsaufnahmen sind in der Fig. 1 nicht dargestellt. Der Verdampfer besteht aus einem gut wärmeleitfähigem Material, beispielsweise aus Aluminium. In die Montageplatte 10 ist ein Rohrleitungssystem eingegossen. Dieses Rohrleitungssystem verläuft mäanderförmig. Das Rohrleitungssystem ist über Kühlmittelleitungen 11 mit einem Kompressor 12 verbunden. Dem Kompressor 12 ist auch eine Regel-Steuereinheit zugeordnet, die die Funktionen des Kühlgerätes laufend überwacht und steuert. Von dem Kompressor 12 gehen Kühlmittelleitungen 13 ab, die an ein Rohrleitungssystem des Verflüssigers 15 angeschlossen sind. Der Verflüssiger 15 ist ähnlich aufgebaut wie die Montageplatte 10. Der Aufbau des Verflüssigers 15 geht näher aus der Fig. 2 hervor.

Wie diese Darstellung erkennen läßt, ist das Rohrleitungssystem 17 in das Material des Verflüssigers 15 eingegossen. Das Material des Verflüssigers 15 ist gut wärmeleitend, wozu der Verflüssiger 15 beispielsweise aus Aluminium besteht. Auf der der Montageplatte 10 abgekehrten Außenseite sind an den Verflüssiger 15 Kühlrippen 16 einstückig angeformt. Der Verfüssiger 15 ist ebenso wie die Montageplatte 10 plattenförmig ausgebildet. Zwischen der Montageplatte 10 und dem Verflüssiger 15 ergibt sich ein Freiraum. Dieser Freiraum ist mit einer Isolierschicht 14 ausgefüllt. Die Isolierschicht 14 entkoppelt den Verflüssiger 15 thermisch von der Montageplatte 10.

Wie die Fig. 1 erkennen läßt, ist der Verflüssiger 15 hinsichtlich seiner Außenabmessungen größer ausgebildet, als die Isolierschicht 14. Damit ergibt sich ein umlaufender Befestigungsflansch. Das Kühlgerät kann als vormontierte Einheit in einen Durchbruch einer Außenverkleidung eines Schaltgehäuses eingesetzt werden. Dabei stützt sich der umlaufende Flansch auf der Außenseite der Außenverkleidung ab und kann mit dieser Verbunden, beispielsweise verschraubt werden. Die Isolierschicht 14 füllt den Ausschnitt der Außenverkleidung in den das Kühlgerät montiert ist, vollständig aus. Auf diese Weise ist verhindert, dass ein Wärmeübergang von dem Verflüssiger 15 in den Schaltgehäuse-Innenraum stattfinden kann. Im montiertem Zustand wird somit der Verflüssiger 15 auf der Außenseite und die Montageplatte 10 im Innenraum des Schaltgehäuses gehalten.

Auf der Montageplatte 10 können, dem Schaltgehäuse-Innenraum zugekehrt, elektrische oder elektronische Komponenten befestigt werden. Dabei stehen diese Komponenten in Oberflächenkontakt mit der Montageplatte 10. Während des Betriebes der Komponenten geben diese ihre Verlustleistung in Form von Wärme an die Montageplatte 10 ab. Da die Montageplatte 10 den Verdampfer des Kältekreislaufes bildet, ist sie stets auf einer niedrigen Betriebstemperatur gehalten, so dass eine effektive Wärmeabfuhr möglich ist. Die Wärme wird in das Rohrleitungssystem und damit in das im Kältekreislauf zirkulierende Kühlmittel eingebracht. Über die Kühlmittelleitungen 11, 13 kann dann das Kühlmittel die Wärme dem Verflüssiger 15 zuführen. Hier erfolgt dann letztendlich auch der Wärmeabtausch mit der Umgebung. Dies ist effektiv möglich, da mittels der Kühlrippen 16 eine große Wärmetausch-Oberfläche geschaffen ist.

## Patentansprüche

1. Schaltschrankgehäuse mit einem Kühlgerät, das einen Kältekreislauf mit einem Verdampfer und einem Verflüssiger (15) aufweist, wobei das Schaltgehäuse eine Außenverkleidung aufweist, die einen Schaltgehäuse-Innenraum zumindest teilweise umgibt, wobei im Schaltgehäuse-Innenraum eine Montageplatte (10) gehalten ist, wobei die Montageplatte (10) als Verdampfer ausgebildet ist, dem ein Rohrleitungssystem zugeordnet ist, in dem das Kältemittel des Kältekreislaufes geführt ist, wobei der plattenförmige Verflüssiger (15) zumindest einen Teil der Außenverkleidung bildet, und dem ebenfalls ein Rohrleitungssystem (17) für das Kältemittel zugeordnet ist, und wobei das Kühlgerät ventilatoren- bzw, lüfterfrei ausgestaltet ist,
**dadurch gekennzeichnet,**
**dass** der Verflüssiger (15), die Montageplatte (10) und ein Kompressor (12) zu einer Montsgeeinheit zusammengefaßt und betriebsbereit miteinander verbunden sind,
**dass** der Verflüssiger (15) beabstandet zu der Montageplatte (10) gehalten ist,
und
**dass** im Zwischenraum zwischen der Montageplatte (10) und dem Verflüssiger (15) die Isolierschicht (14) eingebracht ist, die den Verflüssiger (15) gegenüber der Montageplatte (10) thermisch entkoppelt.

2. Schaltgehäuse nach Anspruch 1
**dadurch gekennzeichnet,**
**dass** der Verflüssiger (15) auf seiner, dem Schaltgehäuse-innenraum zugewandten Seite mittels einer Isolierschicht (14) hinterlegt ist.

3. Schaltgehäuse nach einem der Ansprüche 1 öder 2,
**dadurch gekennzeichnet,**
**dass** der Verflüssiger (15) aus einem wärmeleitfähigen Material besteht, in das das zugeordnete Rohrleitungssystem (17) eingegossen ist.

4. Schaltgehäuse nach Anspruch 3,
**dadurch gekennzeichnet,**
**dass** der Verflüssiger (15) auf seiner, der Umgebung zugeordneten Außenseite einstückig angeformte Kühlrippen (16) aufweist.

5. Schaltschrank nach einem der Ansprüche 1 bis 4,
**dadurch gekennzeichnet,**
**dass** die Montageplatte (10) aus einem wärmeleitfähigen Material besteht, in das das zugeordnete Rohrleitungssystem eingegossen ist.

6. Schaltgehäuse nach einem der Ansprüche 1 bis 5,
**dadurch gekennzeichnet,**
**dass** die Montageplatte (10) eine, dem Schaltgehäuse-Innenraum zugekehrte ebene Montagefläche aufweist, die mit Befestigungsaufnahmen versehen ist.

## Claims

1. Switch-cabinet housing with a cooling means having a refrigeration circuit with an evaporator and a condenser (15), it being the case that the switch housing has an outer cladding which at least partially encloses a switch-housing interior, that an installation panel (10) is retained in the switch-housing interior, that the installation panel (10) is designed as the evaporator, which is assigned a pipeline system in which the refrigerant of the refrigeration circuit is channelled, that the panel-like condenser (15) forms at least part of the outer cladding, and is likewise assigned a pipeline system (17) for the refrigerant, and that the cooling means is configured without a ventilator or fan, **characterized in that** the condenser (15), the installation panel (10) and a compressor (12) are combined to form an installation unit and are connected to one another ready for operation, **in that** the condenser (15) is spaced apart from the installation panel (10), and **in that** the insulating layer (14) is introduced in the interspace between the installation panel (10) and the condenser (15), this insulating layer thermally insulating the condenser (15) from the installation panel (10).

2. Switch housing according to Claim 1, **characterized in that**, on its side which is directed towards the switch-housing interior, the condenser (15) is backed by means of an insulating layer (14).

3. Switch housing according to one of Claims 1 and 2, **characterized in that** the condenser (15) consists of a thermally conductive material in which the associated pipeline system (17) is cast.

4. Switch housing according to Claim 3, **characterized in that** the condenser (15) has integrally formed cooling ribs (16) on its outside, directed towards the surroundings.

5. Switch cabinet according to one of Claims 1 to 4, **characterized in that** the installation panel (10) consists of a thermally conductive material in which the associated pipeline system is cast.

6. Switch housing according to one of Claims 1 to 5, **characterized in that** the installation panel (10) has a planar installation surface which is directed towards the switch-housing interior and is provided with fastening mounts.

## Revendications

1. Boîtier d'armoire de distribution doté d'un appareil de refroidissement qui possède un circuit de refroidissement avec un évaporateur et un condenseur (15), le boîtier de distribution possédant un revêtement extérieur qui entoure au moins partiellement un volume intérieur du boîtier de distribution, une plaque de montage (10) étant maintenue dans le volume intérieur du boîtier de distribution, la plaque de montage (10) étant formée en évaporateur auquel est associé un système de tuyaux de raccordement qui conduit le produit frigorifique du circuit de refroidissement, le condenseur (15) en forme de plaque constituant au moins une partie du revêtement extérieur, et auquel est également associé un système de tuyaux de raccordement (17) pour le produit frigorifique, et l'appareil de refroidissement étant développé sans ventilateurs respectivement ni aérateurs, **caractérisé en ce que** le condenseur (15), la plaque de montage (10) et un compresseur (12) sont assemblés en une unité de montage et sont raccordés entre eux pour être prêts pour l'utilisation, **en ce que** le condenseur (15) est maintenu à distance de la plaque de montage (10), et que dans l'espace entre la plaque de montage (10) et le condenseur (15) est insérée la couche d'isolation (14) qui découple thermiquement 1e condenseur (15) par rapport à la plaque de montage (10).

2. Boîtier de distribution selon la revendication 1, **caractérisé en ce que** le condenseur (15) est fixé sur son côté orienté vers le volume intérieur du boîtier de distribution au moyen d'une couche isolante (14).

3. Boîtier de distribution selon une des revendications 1 ou 2, **caractérisé en ce que** le condenseur (15) est constitué d'un matériau conducteur de la chaleur dans lequel est noyé le système de tuyaux de raccordement (17) associé.

4. Boîtier de distribution selon la revendication 3, **caractérisé en ce que** le condenseur (15) présente des ailettes de refroidissement (16) qui épousent d'une pièce son côté extérieur orienté vers l'environnement.

5. Boîtier de distribution selon une des revendications 1 à 4, **caractérisé en ce que** la plaque de montage (10) est constituée d'un matériau conducteur de la chaleur dans lequel est noyé le système de tuyaux de raccordement associé.

6. Boîtier de distribution selon une des revendications 1 à 5, **caractérisé en ce que** la plaque de montage (10) possède une surface de montage plane, orientée vers le volume intérieur du boîtier de distribution, qui est pourvue d'ouvertures de fixation.
